(19) Europäisches Patentamt
European Patent Office
Office européen des brevets

(11) **EP 3 276 547 A1**

(12) **EUROPEAN PATENT APPLICATION**

(43) Date of publication:
**31.01.2018 Bulletin 2018/05**

(51) Int Cl.:
***G06Q 10/06*** *(2012.01)* ***G06Q 99/00*** *(2006.01)*

(21) Application number: **16200592.0**

(22) Date of filing: **24.11.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **27.07.2016 KR 20160095168**

(71) Applicant: **Korea Meteorological Administration Seoul 07062 (KR)**

(72) Inventors:
• **JIWON, Choi**
  **Seoul (KR)**
• **KI-HO, Chang**
  **Seoul (KR)**
• **EUNSIL, Jung**
  **SEOUL (KR)**
• **JIN-YIM, Jeong**
  **SEOUL (KR)**
• **BAEK-JO, Kim**
  **SEOUL (KR)**

(74) Representative: **Rüger, Barthelt & Abel Patentanwälte**
**Webergasse 3**
**73728 Esslingen (DE)**

(54) **SYSTEM AND METHOD FOR DETERMINING WHETHER TO PERFORM GLACIOGENIC SEEDING**

(57) Disclosed herein are a system and method for determining whether to perform airborne glaciogenic seeding experiments through numerical simulations. The method and system may include analyzing weather factors of a target area for airborne glaciogenic seeding experiments, determining whether airborne experiments are possible based on the direction of the wind, the velocity of the wind, temperature and humidity in the target area, determining seeding information by taking into consideration the direction of the wind and the velocity of the wind, performing numerical simulations using the seeding information, displaying and calculating a seeding material spread and distribution field using the results of the numerical simulations, displaying a precipitation increment and a region, and calculating an area, and determining whether a seeding effect is present or not using the displayed and calculated results.

**EP 3 276 547 A1**

**Description**

**CROSS REFERENCE TO RELATED APPLICATION**

The present application claims the benefit of Korean Patent Application No. 10-2016-0095168 filed in the Korean Intellectual Property Office on 27 July, 2016, the entire contents of which are incorporated herein by reference.

BACKGROUND OF THE INVENTION

1. Technical Field

An embodiment of the present invention relates to a system and method for determining whether to perform airborne glaciogenic seeding experiments through numerical simulations.

2. Description of the Related Art

Glaciogenic seeding refers to a technology for making artificial snow by spraying silver iodide (AgI) that creates ice crystals using cloud seeds onto cold clouds (clouds of 0°C or less) in the winter season. Such glaciogenic seeding is performed in terms of securing water resources and divided into airborne experiments and ground experiments.

Silver iodide, that is, a seeding material, is colorless and odorless, and thus it is difficult to check where the seeding material has been spread by a naked eye. Furthermore, there is a difficulty in detecting snowfall enhancement because observation devices for measuring snowfall enhancement which may be called a seeding effect are installed on limited places.

Airborne glaciogenic seeding experiments require the topography and weather condition of an area where the experiments are to be performed, experiment equipment, and a corresponding experiment design according to the volume. In airborne experiments, pieces of information about seeding for the execution of experiments chiefly depend on a weather condition. Accordingly, it is necessary to check the path and seeding effect of a seeding material in advance by exchanging a flight path and the amount of seeding in advance using a forecast field and performing numerical simulations.

In a conventional technology, however, there is a problem in that it is difficult to predict the results of airborne experiments for artificial snow enhancement because pieces of information about seeding for the execution of experiments chiefly depends on weather conditions in such airborne experiments.

SUMMARY OF THE INVENTION

Accordingly, the present invention has been made keeping in mind the above problem occurring in the prior art, and an object of the present invention is to determine whether to perform airborne experiments by calculating a seeding line, a seeing period, the amount of seeding and a seeding altitude with consideration taken of an average direction and velocity of the wind when the airborne experiments are performed based on a detailed forecast field provided by the weather center using a numerical model and checking the spread of a seeding material and a distribution (i.e., a target area) of snowfall enhancement attributable to the seeding and to increase a rate of success of the airborne glaciogenic seeding experiments.

In accordance with an embodiment of the present invention, a method for determining whether to perform airborne glaciogenic seeding experiments through numerical simulations includes a first step for analyzing, by a weather factor analysis unit, weather factors of a target area for airborne glaciogenic seeding experiments, a second step for determining, by an airborne experiment possibility determination unit, whether airborne experiments are possible based on the direction of the wind, the velocity of the wind, temperature and humidity in the target area, a third step for determining, by a seeding information determination unit, seeding information by taking into consideration the direction of the wind and the velocity of the wind, a fourth step for performing, by a numerical simulation execution unit, numerical simulations using the seeding information, a fifth step for displaying and calculating, by an experiment calculation unit, a seeding material spread and distribution field using the results of the numerical simulations, displaying a precipitation increment and a region, and calculating an area, and a sixth step for determining, by a seeding effect determination unit, whether a seeding effect is present or not using the displayed and calculated results.

In accordance with another embodiment of the present invention, in the first step, the weather factor analysis unit may analyze the velocity of the wind, the direction of the wind, the temperature and the humidity, that is, weather factors of an experiment area for the airborne glaciogenic seeding experiments, using the vertical time-series diagram of weather center forecast data.

In accordance with another embodiment of the present invention, in the third step, the seeding information determination unit may determine the seeding information, including a seeding line, a seeding altitude, a seeding start time, a seeding termination time and the amount of seeding, by taking into consideration the direction of the wind and the velocity of the wind.

In accordance with another embodiment of the present invention, in the fourth step, the numerical simulation execution unit may generate information about a point, time and altitude regarding the domain of the seeding information using the seeding information and may perform SEED numerical experiments and criterion experiments or NOSEED experiments numerical simulations.

In accordance with another embodiment of the present invention, in the sixth step, the seeding effect determination unit may determine whether a seeding effect is present or not based on whether the seeding material has reached the target area or not and a precipitation increment and precipitation increase area attributable to the seeding using the displayed and calculated results.

In accordance with another embodiment of the present invention, the method may further include a seventh step for performing experiments or not performing experiments based on a result of the determination of whether a seeding effect is present or not.

In accordance with an embodiment of the present invention, a system for determining whether to perform airborne glaciogenic seeding experiments through numerical simulations includes a weather factor analysis unit configured to analyze weather factors of a target area for airborne glaciogenic seeding experiments, an airborne experiment possibility determination unit configured to determine whether airborne experiments are possible based on the direction of the wind, the velocity of the wind, temperature and humidity in the target area, a seeding information determination unit configured to determine seeding information by taking into consideration the direction of the wind and the velocity of the wind, a numerical simulation execution unit configured to perform numerical simulations using the seeding information, an experiment calculation unit configured to display and calculate a seeding material spread and distribution field using the results of the numerical simulations, display a precipitation increment and a region, and calculate an area, and a seeding effect determination unit configured to determine whether a seeding effect is present or not using the displayed and calculated results.

In accordance with another embodiment of the present invention, the weather factor analysis unit may analyze the velocity of the wind, the direction of the wind, the temperature and the humidity, that is, weather factors of an experiment area for the airborne glaciogenic seeding experiments, using the vertical time-series diagram of weather center forecast data.

In accordance with another embodiment of the present invention, the seeding information determination unit may determine the seeding information including a seeding line, a seeding altitude, a seeding start time, a seeding termination time and the amount of seeding by taking into consideration the direction of the wind and the velocity of the wind.

In accordance with another embodiment of the present invention, the numerical simulation execution unit may generate information about a point, time and altitude regarding the domain of the seeding information using the seeding information and may perform SEED numerical experiments and criterion experiments or NOSEED experiments numerical simulations.

In accordance with another embodiment of the present invention, the seeding effect determination unit may determine whether a seeding effect is present or not based on whether the seeding material has reached the target area or not and a precipitation increment and precipitation increase area attributable to the seeding using the displayed and calculated results.

BRIEF DESCRIPTION OF THE DRAWINGS

FIG. 1 is a flowchart illustrating a method for determining whether to perform airborne glaciogenic seeding experiments through numerical simulations in accordance with an embodiment of the present invention.

FIG. 2 shows a vertical time-series diagram calculated through a RDAPS forecast field in accordance with an embodiment of the present invention.

FIG. 3 is a condition table for determining whether an airborne experiment is possible or not in accordance with an embodiment of the present invention.

FIG. 4 is a conceptual diagram for setting a seeding line for 8 bearings in accordance with an embodiment of the present invention.

FIG. 5 is a conceptual diagram illustrating the execution of a numerical model in accordance with an embodiment of the present invention.

FIG. 6 is a circular distribution diagram of a seeding material in a seeding altitude in accordance with an embodiment of the present invention.

FIG. 7 is a diagram displaying an expected precipitation increment and increase areas attributable to seeding in accordance with an embodiment of the present invention.

FIG. 8 is a diagram showing the configuration of a system for determining whether to perform airborne glaciogenic seeding experiments through numerical simulations in accordance with an embodiment of the present invention.

<Description of reference numerals>

210: system for determining whether to perform airborne glaciogenic seeding experiments through numerical simulations
211: weather factor analysis unit
212: airborne experiment possibility determination unit
213: seeding information determination unit
214: numerical simulation execution unit
215: experiment calculation unit
216: seeding effect determination unit

DETAILED DESCRIPTION

Hereinafter, embodiments of the present invention are described in detail with reference to the accompanying drawings. However, in describing the embodiments, a detailed description of the known function or element related to the present invention will be omitted if it is deemed to make the gist of the present invention unnecessarily vague. Furthermore, it is to be noted that in the drawings, the size of each element may have been exaggerated and does not correspond to an actual size.

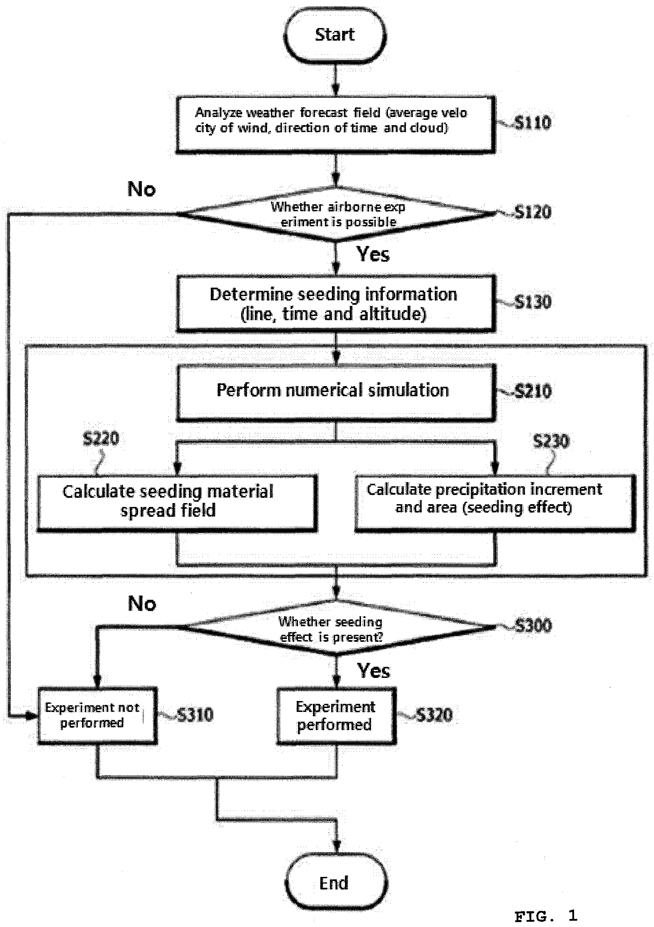

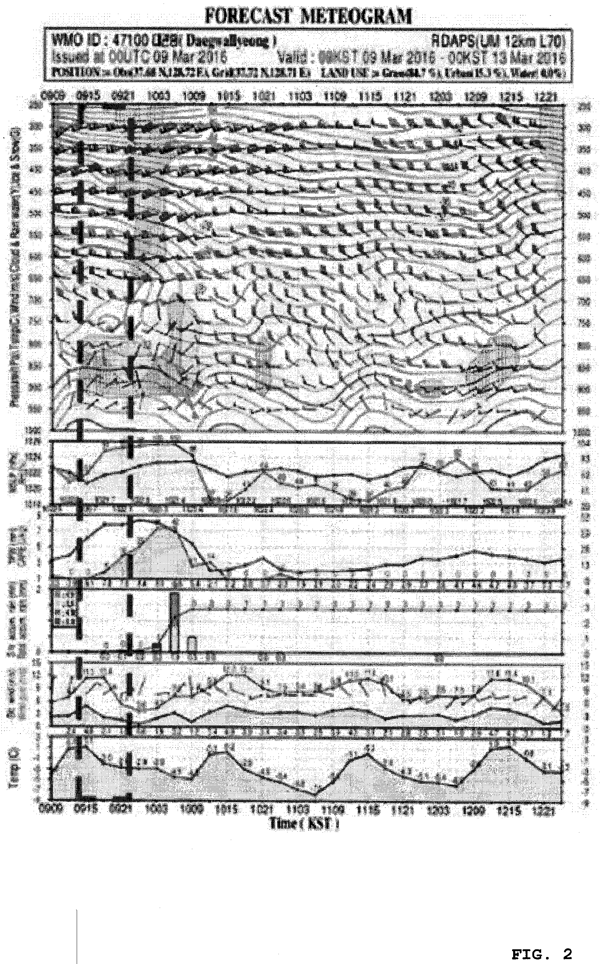

FIG. 1 is a flowchart illustrating a method for determining whether to perform airborne glaciogenic seeding experiments through numerical simulations in accordance with an embodiment of the present invention. FIGS. 2 to 7 are diagrams for illustrating the method for determining whether to perform airborne glaciogenic seeding experiments through numerical simulations in accordance with an embodiment of the present invention.

Hereinafter, the method for determining whether to perform airborne glaciogenic seeding experiments through numerical simulations in accordance with an embodiment of the present invention is described with reference to FIG. 1.

First, a weather factor analysis unit analyzes the weather factors of an experiment area on which airborne glaciogenic seeding experiments are to be performed at step S110.

In this case, the weather factor analysis unit may analyze the velocity of the wind, the direction of the wind, temperature and humidity, that is, the weather factors of the experiment area on which airborne glaciogenic seeding experiments are to be performed using a vertical time-series diagram of weather center forecast data.

More specifically, the weather factor analysis unit may analyze whether the inflow of clouds is present or not and weather factors (e.g., the velocity of the wind, the direction of the wind, temperature and humidity) in a target area on which airborne glaciogenic seeding experiments are to be performed, for example, the Daegwallyeong district where Yongpyong ski resorts is located using the vertical time-series diagram of the weather center forecast data (UMRDAPS) shown in FIG. 2.

Thereafter, an airborne experiment possibility determination unit determines whether airborne experiments are possible or not based on the direction of the wind, the velocity of the wind, temperature and humidity of the target area at step S120.

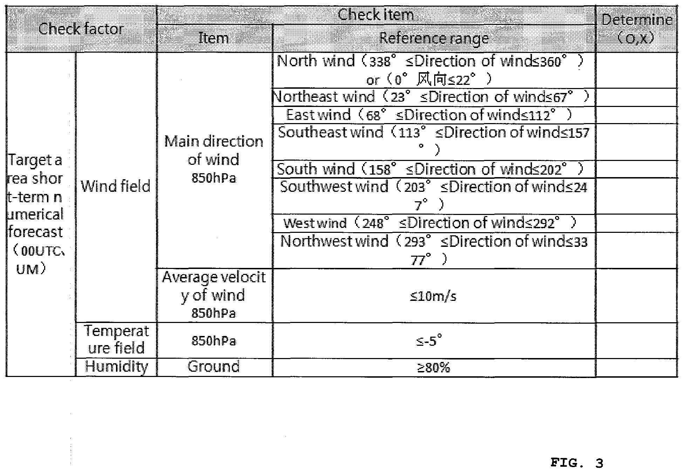

More specifically, the airborne experiment possibility determination unit determines whether an airborne experiment is possible or not based on forecast data. In this case, a condition on the determination may be determined to be possible if all of conditions are satisfied in a condition table for determining whether an airborne experiment is possible or not in FIG. 3. For example, if it is expected that airborne experiments are possible because the velocity of the wind of 10 m/s or less, -5°C or less and humidity of 80% or more are satisfied in the target area, a next step may be performed. If not, experiments may be determined to be not performed.

Thereafter, a seeding information determination unit determines seeding information by taking into consideration the direction of the wind and the velocity of the wind at step S130.

In this case, the seeding information determination unit may determine the seeding information, including a seeding line, a seeding altitude, a seeding start time, a seeding termination time and the amount of seeding, by taking into consideration the direction of the wind and the velocity of the wind.

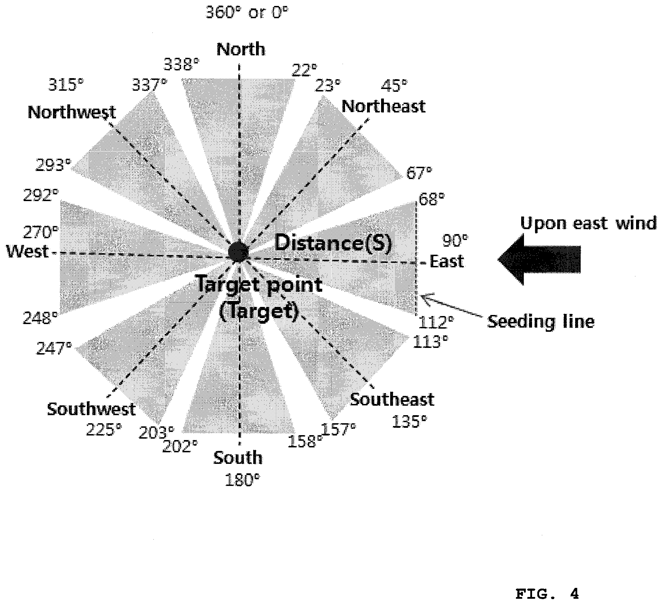

More specifically, as shown in FIG. 4 showing a conceptual diagram for setting a seeding line for 8 bearings, the seeding line is calculated by calculating a distance S to a target point based on 8 bearings (north, northeast, east, southeast, south, southwest, west and northwest). The distance S is calculated by Equation 1 below.

[Equation 1]

S = average velocity of wind [unit: m/s] X response

time [unit: seconds (s)]

In this case, an average velocity of the wind calculated using the vertical time-series diagram of the forecast field shown in FIG. 2 is used as the average velocity of the wind. The response time refers to the time that is taken for the seeding material to enter the clouds and to become snow through an ice crystal uncleation process.

For example, assuming that the response time is 30 minutes, the response time is 1800s, that is, 30 minutes X 60. Assuming that the average velocity of the wind is 5 m/s, S = 5 m/s X 1800 s = 9000 m = 9 km.

Thereafter, a numerical simulation execution unit performs numerical simulations using the seeding information at step S210.

In this case, the numerical simulation execution unit may generate information about a point, time and an altitude regarding the domain of the seeding information using the seeding information, and may perform glaciogenic seeding experiments (i.e., seeding numerical experiments) and criterion experiments or non-seeding experiments numerical simulations.

For example, the numerical simulation execution unit selects 6 hours anterior and posterior to a determined seeding time as a simulation time, calculates an input field and a boundary field using the weather forecast data (e.g., UM LDAPS) on the basis of the seeding line, and generates a file "air.seed.txt", that is, information about a point, time and an altitude regarding the seeding information by inputting a seeding start point S1 (latitude, longitude), a seeding end point S2 (latitude, longitude), a seeding start time, a seeding termination time and the amount of seeding, that is, pieces of information about seeding by executing aircraft.csh shell.

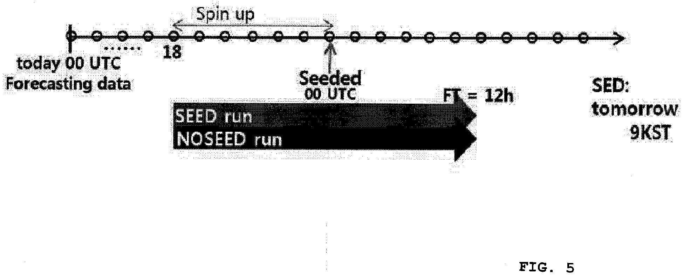

In this case, first, SEED numerical experiments (glaciogenic seeding experiments) are performed with 1km resolution and NOSEED experiments (criterion experiments or non-seeding experiments) are performed at the same time. FIG. 5 is a diagram showing a concept regarding such numerical experiments.

Thereafter, an experiment calculation unit displays and calculates a seeding material spread and distribution field using the results of the numerical simulations, displays a precipitation increment and a region, and calculates areas at steps S220 and S230.

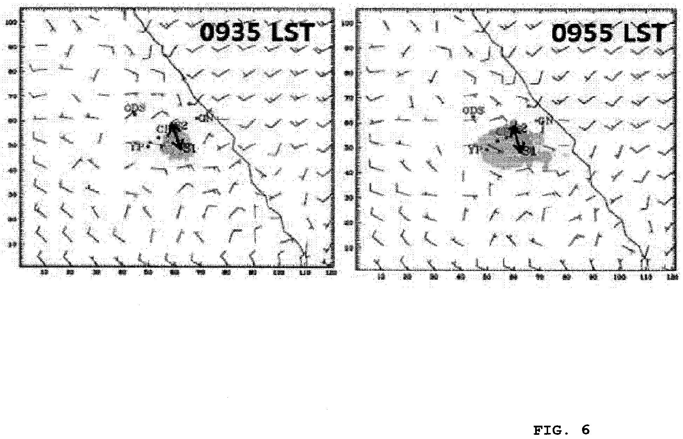

More specifically, the experiment calculation unit displays and calculates the seeding material spread and distribution field through the results of the SEED numerical experiments (glaciogenic seeding experiments). FIG. 6 shows a distribution of a spread seeding material based on the results of the SEED numerical experiments. The spread diagram of FIG. 6 shows an area regarding whether the seeding material reaches a target point after several minutes from a seeding start time.

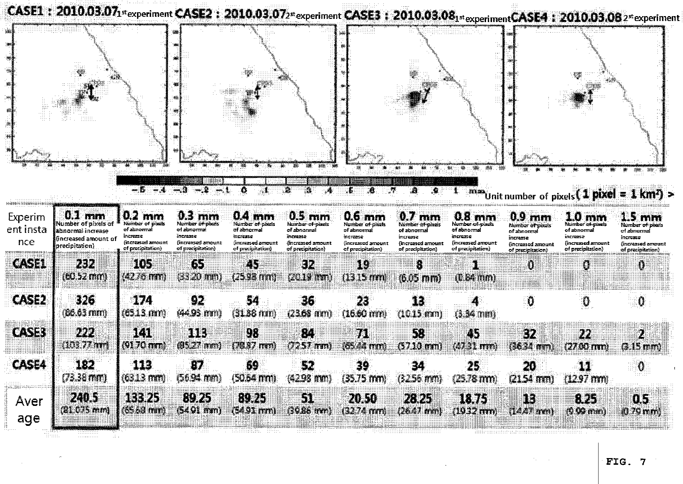

Furthermore, the experiment calculation unit may display a precipitation increment and a region attributable to the experiments based on a difference between the amount of precipitation in the SEED numerical experiments and the amount of precipitation in the NOSEED numerical experiments, and may calculate areas, as shown in FIG. 7. In this case, the area is calculated by reading a SEED experiment file and a NOSEED experiment file, calculating a difference (SEED and NOSEED) between the accumulated amounts of precipitation in about 3 hours after the seeding is terminated, and calculating the number of pixels whose value is 0.1 mm or more. One pixel is 1km^2. Accordingly, the number of pixels in which a precipitation increase has occurred indicates an area.

Thereafter, a seeding effect determination unit determines whether a seeding effect is present or not using the displayed and calculated results at step S300.

In this case, the seeding effect determination unit may determine whether a seeding effect is present or not based on whether the seeding material has reached the target area or not and a precipitation increment and a precipitation increase area attributable to the seeding using the displayed and calculated results.

For example, a criterion for determining whether a seeding effect is present or not may include whether a seeding material has reached the target area or not and a precipitation increase of 0.1 mm or more and a precipitation increase area of 100 km$^2$ or more attributable to the seeding. In this case, the criteria, that is, the numerical values of the precipitation increase of 0.1 mm and the area of 100 km$^2$, may be changed.

Experiments may be performed or not based on the results of the determination of whether a seeding effect is present or not.

That is, if it is determined that a seeding effect is not present, experiments are determined to be not performed at step S310. If it is determined that a seeding effect is present, experiments are determined to be performed at step S320.

As described above, in the method for determining whether to perform airborne glaciogenic seeding experiments through numerical simulations in accordance with an embodiment of the present invention, a seeding line, a seeing period, the amount of seeding and a seeding altitude are calculated by taking into consideration an average direction and velocity of the wind when airborne experiments are performed based on a weather center detailed forecast field. The spread of a seeding material and a distribution (i.e., a target area) of glaciogenic seeding attributable to the seeding are checked through simulations using a numerical model. Accordingly, whether to perform experiments can be determined, and a rate of success of corresponding airborne glaciogenic seeding experiments can be improved.

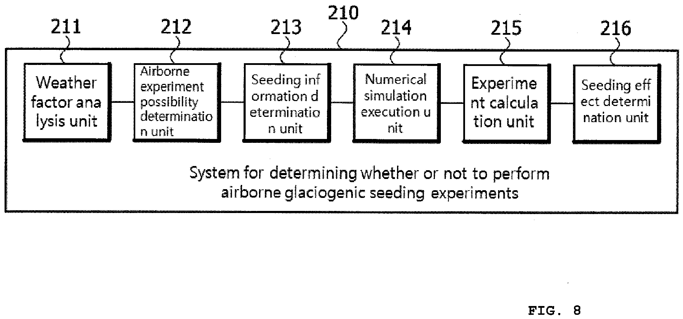

FIG. 8 is a diagram showing the configuration of a system for determining whether to perform airborne glaciogenic seeding experiments through numerical simulations in accordance with an embodiment of the present invention.

Hereinafter, the configuration of the system for determining whether to perform airborne glaciogenic seeding experiments through numerical simulations in accordance with an embodiment of the present invention is described with reference to FIG. 8.

As shown in FIG. 8, the system 210 for determining whether to perform airborne glaciogenic seeding experiments through numerical simulations in accordance with an embodiment of the present invention is configured to include the weather factor analysis unit 211, the airborne experiment possibility determination unit 212, the seeding information determination unit 213, the numerical simulation execution unit 214, the experiment calculation unit 215, and the seeding effect determination unit 216.

The weather factor analysis unit 211 analyzes the weather factors of a target area on which airborne glaciogenic seeding experiments are to be performed.

In this case, the weather factor analysis unit 211 may analyze the velocity of the wind, the direction of the wind, temperature and humidity, that is, the weather factors of a target area on which airborne glaciogenic seeding experiments are to be performed, using the vertical time-series diagram of weather center forecast data.

The airborne experiment possibility determination unit 212 determines whether airborne experiments are possible based on the direction of the wind, the velocity of the wind, temperature and humidity of the target area.

The seeding information determination unit 213 determines seeding information by taking into consideration the direction of the wind and the velocity of the wind.

In this case, the seeding information determination unit 213 may determine the seeding information, including a seeding line, a seeding altitude, a seeding start time, a seeding termination time and the amount of seeding by taking into consideration the direction of the wind and the velocity of the wind.

Furthermore, the numerical simulation execution unit 214 performs numerical simulations using the seeding information.

More specifically, the numerical simulation execution unit 214 may generate information about a point, time and an altitude regarding the domain of the seeding information using the seeding information, and may perform glaciogenic seeding experiments (SEED numerical experiments) and criterion experiments or NOSEED experiments numerical simulations.

The experiment calculation unit 215 displays and calculates a seeding material spread and distribution field using the results of the numerical simulations, displays a precipitation increment and a region, and calculates an area.

Accordingly, the seeding effect determination unit 216 may determine whether a seeding effect is present or not using the displayed and calculated results.

In this case, the seeding effect determination unit 216 may be configured to determine whether a seeding effect is present or not based on whether the seeding material has reached the target area or not and a precipitation increment and a precipitation increase attributable to the seeding using the displayed and calculated results.

In accordance with an embodiment of the present invention a seeding line, a seeing period, the amount of seeding and a seeding altitude are calculated by taking into consideration an average direction and velocity of the wind when airborne experiments are performed based on a weather center detailed forecast field. The spread of a seeding material and a distribution (i.e., a target area) of glaciogenic seeding attributable to the seeding are checked through simulations using a numerical model. Accordingly, whether to perform experiments can be determined, and a rate of success of corresponding airborne glaciogenic seeding experiments can be improved.

As described above, the detailed embodiments of the present invention have been described in the detailed description. However, the present invention may be modified in various ways without departing from the category of the invention. Accordingly, the technical spirit of the present invention should not be limited to the aforementioned embodiments, but should be defined by not only the appended claims, but equivalents thereof.

## Claims

1. A method for determining whether to perform airborne glaciogenic seeding experiments through numerical simulations, the method comprising:

   a first step for analyzing, by a weather factor analysis unit, weather factors of a target area for airborne glaciogenic seeding experiments;

a second step for determining, by an airborne experiment possibility determination unit, whether airborne experiments are possible based on a direction of the wind, a velocity of the wind, temperature and humidity in the target area;

a third step for determining, by a seeding information determination unit, seeding information by taking into consideration the direction of the wind and the velocity of the wind;

a fourth step for performing, by a numerical simulation execution unit, numerical simulations using the seeding information;

a fifth step for displaying and calculating, by an experiment calculation unit, a seeding material spread and distribution field using results of the numerical simulations, displaying a precipitation increment and a region, and calculating an area; and

a sixth step for determining, by a seeding effect determination unit, whether a seeding effect is present or not using the displayed and calculated results.

2. The method of claim 1, wherein in the first step, the weather factor analysis unit analyzes the velocity of the wind, the direction of the wind, the temperature and the humidity which are the weather factors of an experiment area for the airborne glaciogenic seeding experiments using a vertical time-series diagram of weather center forecast data.

3. The method of claim 1, wherein in the third step, the seeding information determination unit determines the seeding information comprising a seeding line, a seeding altitude, a seeding start time, a seeding termination time and an amount of seeding by taking into consideration the direction of the wind and the velocity of the wind.

4. The method of claim 1, wherein in the fourth step, the numerical simulation execution unit generates information about a point, time and altitude regarding a domain of the seeding information using the seeding information and performs SEED numerical experiments and criterion experiments or NOSEED experiments numerical simulations.

5. The method of claim 1, wherein in the sixth step, the seeding effect determination unit determines whether a seeding effect is present or not based on whether the seeding material has reached the target area or not and a precipitation increment and precipitation increase area attributable to the seeding using the displayed and calculated results.

6. The method of claim 1, further comprising a seventh step for performing experiments or not performing experiments based on a result of the determination of whether a seeding effect is present or not.

7. A system for determining whether to perform airborne glaciogenic seeding experiments through numerical simulations, the system comprising:

a weather factor analysis unit configured to analyze weather factors of a target area for airborne glaciogenic seeding experiments;

an airborne experiment possibility determination unit configured to determine whether airborne experiments are possible based on a direction of the wind, a velocity of the wind, temperature and humidity in the target area;

a seeding information determination unit configured to determine seeding information by taking into consideration the direction of the wind and the velocity of the wind;

a numerical simulation execution unit configured to perform numerical simulations using the seeding information;

an experiment calculation unit configured to display and calculate a seeding material spread and distribution field using results of the numerical simulations, display a precipitation increment and a region, and calculate an area; and

a seeding effect determination unit configured to determine whether a seeding effect is present or not using the displayed and calculated results.

8. The system of claim 7, wherein the weather factor analysis unit analyzes the velocity of the wind, the direction of the wind, the temperature and the humidity which are the weather factors of an experiment area for the airborne glaciogenic seeding experiments using a vertical time-series diagram of weather center forecast data.

9. The system of claim 7, wherein the seeding information determination unit determines the seeding information comprising a seeding line, a seeding altitude, a seeding start time, a seeding termination time and an amount of seeding by taking into consideration the direction of the wind and the velocity of the wind.

10. The system of claim 7, wherein the numerical simulation execution unit generates information about a point, time and altitude regarding a domain of the seeding information using the seeding information and performs SEED numerical experiments and criterion experiments or NOSEED experiments numerical simulations.

11. The system of claim 7, wherein the seeding effect determination unit determines whether a seeding effect is present or not based on whether the seeding material has reached the target area or not and a precipitation increment and precipitation increase area attributable to the seeding using the displayed and calculated results.

FIG. 1

## FORECAST METEOGRAM

FIG. 2

| Check factor | | Check item | | Determine |
|---|---|---|---|---|
| | | Item | Reference range | (O,X) |
| Target area short-term numerical forecast (00UTC, UM) | Wind field | Main direction of wind 850hPa | North wind (338° ≤Direction of wind≤360°) or (0° 风向≤22°) | |
| | | | Northeast wind (23° ≤Direction of wind≤67°) | |
| | | | East wind (68° ≤Direction of wind≤112°) | |
| | | | Southeast wind (113° ≤Direction of wind≤157°) | |
| | | | South wind (158° ≤Direction of wind≤202°) | |
| | | | Southwest wind (203° ≤Direction of wind≤247°) | |
| | | | West wind (248° ≤Direction of wind≤292°) | |
| | | | Northwest wind (293° ≤Direction of wind≤337°) | |
| | | Average velocity of wind 850hPa | ≤10m/s | |
| | Temperature field | 850hPa | ≤-5° | |
| | Humidity | Ground | ≥80% | |

FIG. 3

FIG. 4

Spin up

today 00 UTC
Forecasting data

18

Seeded
00 UTC

SEED run
NOSEED run

FT = 12h

SED:
tomorrow
9KST

FIG. 5

FIG. 6

CASE1 : 2010.03.07 1st experiment CASE2 : 2010.03.07 2st experiment CASE3 : 2010.03.08 1st experiment CASE4 : 2010.03.08 2st experiment

< Unit number of pixels ( 1 pixel = 1 km² ) >

| Experiment instance | 0.1 mm Number of pixels of abnormal increase (increased amount of precipitation) | 0.2 mm Number of pixels of abnormal increase (increased amount of precipitation) | 0.3 mm Number of pixels of abnormal increase (increased amount of precipitation) | 0.4 mm Number of pixels of abnormal increase (increased amount of precipitation) | 0.5 mm Number of pixels of abnormal increase (increased amount of precipitation) | 0.6 mm Number of pixels of abnormal increase (increased amount of precipitation) | 0.7 mm Number of pixels of abnormal increase (increased amount of precipitation) | 0.8 mm Number of pixels of abnormal increase (increased amount of precipitation) | 0.9 mm Number of pixels of abnormal increase (increased amount of precipitation) | 1.0 mm Number of pixels of abnormal increase (increased amount of precipitation) | 1.5 mm Number of pixels of abnormal increase (increased amount of precipitation) |
|---|---|---|---|---|---|---|---|---|---|---|---|
| CASE1 | 232 (60.52 mm) | 105 (42.76 mm) | 65 (33.20 mm) | 45 (25.98 mm) | 32 (20.19 mm) | 19 (13.15 mm) | 8 (6.05 mm) | 1 (0.84 mm) | 0 | 0 | 0 |
| CASE2 | 326 (86.63 mm) | 174 (65.13 mm) | 92 (44.93 mm) | 54 (31.88 mm) | 36 (23.68 mm) | 23 (16.60 mm) | 13 (10.15 mm) | 4 (3.54 mm) | 0 | 0 | 0 |
| CASE3 | 222 (103.77 mm) | 141 (91.70 mm) | 113 (85.27 mm) | 98 (78.87 mm) | 84 (72.57 mm) | 71 (65.44 mm) | 58 (57.10 mm) | 45 (47.31 mm) | 32 (36.34 mm) | 22 (27.90 mm) | 2 (3.15 mm) |
| CASE4 | 182 (73.38 mm) | 113 (63.13 mm) | 87 (56.94 mm) | 69 (50.64 mm) | 52 (42.98 mm) | 39 (35.75 mm) | 34 (32.56 mm) | 25 (25.78 mm) | 20 (21.54 mm) | 11 (12.97 mm) | 0 |
| Average | 240.5 (81.075 mm) | 133.25 (65.68 mm) | 89.25 (54.91 mm) | 89.25 (54.91 mm) | 51 (39.86 mm) | 20.50 (32.74 mm) | 28.25 (26.47 mm) | 18.75 (19.32 mm) | 13 (14.47 mm) | 8.25 (0.99 mm) | 0.5 (0.79 mm) |

FIG. 7

211      212      213    210  214      215      216

| Weather factor ana lysis unit | Airborne experiment possibility determinatio n unit | Seeding inf ormation d eterminatio n unit | Numerical simulation execution u nit | Experime nt calcula tion unit | Seeding eff ect determi nation unit |

System for determining whether or not to perform
airborne glaciogenic seeding experiments

FIG. 8

Europäisches
Patentamt

European
Patent Office

Office européen
des brevets

## EUROPEAN SEARCH REPORT

Application Number

EP 16 20 0592

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/148100 A1 (CHANG SEOK-WOONG [KR] ET AL) 26 May 2016 (2016-05-26) * paragraph [0061] - paragraph [0232]; figures 1,2,4,8 * | 1-11 | INV. G06Q10/06 G06Q99/00 |
| X | US 2016/055275 A1 (WANG MENGJIAO [CN] ET AL) 25 February 2016 (2016-02-25) * paragraph [0028] - paragraph [0064]; figures 1,3 * | 1-11 | |
| X | US 7 305 304 B2 (LEYTON STEPHEN M [US] ET AL) 4 December 2007 (2007-12-04) * column 3, line 24 - column 8, line 37; figure 1 * | 1-11 | |

TECHNICAL FIELDS
SEARCHED     (IPC)

G06Q

The present search report has been drawn up for all claims

| Place of search | Date of completion of the search | Examiner |
|---|---|---|
| Munich | 26 January 2017 | Pastore, Edoardo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 16 20 0592

This annex lists the patent family members relating to the patent documents cited in the above-mentioned European search report.
The members are as contained in the European Patent Office EDP file on
The European Patent Office is in no way liable for these particulars which are merely given for the purpose of information.

26-01-2017

| Patent document cited in search report | | Publication date | Patent family member(s) | | Publication date |
|---|---|---|---|---|---|
| US 2016148100 | A1 | 26-05-2016 | US 2016148100 A1<br>WO 2015105277 A1 | | 26-05-2016<br>16-07-2015 |
| US 2016055275 | A1 | 25-02-2016 | NONE | | |
| US 7305304 | B2 | 04-12-2007 | NONE | | |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020160095168